# EUROPEAN PATENT SPECIFICATION

(11) **EP 4 086 644 B1**
(45) Date of publication and mention of the grant of the patent: **15.07.2026**
(21) Application number: 21172662.5
(22) Date of filing: 07.05.2021
(51) Int. Cl.: G01R 31/50, G01R 31/58

(54) **MEASURING DEVICE AND DIAGNOSTIC METHOD FOR A HIGH-VOLTAGE VEHICLE ELECTRICAL SYSTEM**
MESSVORRICHTUNG UND DIAGNOSEVERFAHREN FÜR EIN ELEKTRISCHES HOCHSPANNUNGSSYSTEM EINES FAHRZEUGS
DISPOSITIF DE MESURE ET PROCÉDÉ DE DIAGNOSTIC POUR UN SYSTÈME ÉLECTRIQUE DE VÉHICULE À HAUTE TENSION

(43) Date of publication of application: 09.11.2022
(73) Proprietor: MAHLE International GmbH, 70376 Stuttgart (DE)
(72) Inventor: CROWLEY, Luke, Northampton, NN1 5QZ (GB); LINEHAN, Mike, Nothampton, NN4 6SB (GB); STEVENS, Adam, Roade, NN7 2QQ (GB)
(74) Representative: BRP Renaud & Partner mbB Rechtsanwälte Patentanwälte Steuerberater

(56) References cited:
- US-A1- 2011 242 989
- US-A1- 2014 320 149
- US-A1- 2019 128 948
- US-A1- 2020 094 682

## Description

The invention relates to a measuring device for a test section of a high-voltage vehicle electrical system arranged in a vehicle. The invention, furthermore, relates to a use of this measuring device and to a diagnostic method for determining an operating state of a test section of an electrical high-voltage conductor of a high-voltage vehicle electrical system arranged in a vehicle having such a measuring device.

A measuring device or a diagnostic method for determining an operating state of a test section for a test section is described for example in the document US 3626248 A, US 2019/128948 A1, US 2014/320149 A1, US 2011/242989 A1, US 2020/094682 A1. Disadvantageous in this is that capacitive interference influences in the electrical conductor have a relatively major influence on the measuring device or the diagnostic method, although measuring devices or diagnostic methods that are insensitive or at least relatively insensitive to capacitive interference influences are desirable.

The object of the invention is therefore to provide an improved or at least another embodiment of a measuring device for a test section of a high-voltage vehicle electrical system arranged in a vehicle, a use of the same and a diagnostic method for determining an operating state of a test section of a high-voltage vehicle electrical system arranged in a vehicle having such a measuring device.

In the present invention, this object is solved with the features of the independent claims. Advantageous embodiments are subject of the dependent claims. Additionally, the description and drawings also present further examples, implementations, example embodiments, non-claimed embodiments, etc. for the better understanding of the invention disclosed by the embodiments defined in the appended claims.

The basic idea of the invention lies in that for testing the state of a test section a test voltage signal is initially coupled into an electrical high-voltage conductor, the same passes through the test section and is then uncoupled at another point, wherein the electrical high-voltage conductor is electrically isolated from a sending device and a receiving device of the measuring device.

For this purpose, a measuring device for a test section of a high-voltage vehicle electrical system arranged in an electric vehicle is provided, wherein the same comprises:
- At least one sending device assigned to an electrical high-voltage conductor of a high-voltage vehicle electrical system, in particular a 5 volt to 1000 volt direct high-voltage vehicle electrical system or particularly a 48 volt direct high-voltage vehicle electrical system, which during its operation provide a test voltage signal and can couple the same into this electrical high-voltage conductor.
- A test voltage signal, which during the operation of the sending device is provided by the same and coupled into the electrical high-voltage conductor. Practically, the high-voltage vehicle electrical system or the electrical high-voltage conductor comprises multiple separate measuring points at which such a sending device can be arranged in each case.
- A receiving device assigned to the electrical high-voltage conductor, which can detect the test voltage signal coupled into the electrical high-voltage conductor.
- At least one electrically conductive test section that is connected to the electrical high-voltage conductor in an electrically conductive manner, via which the sending device and the receiving device are or can be electrically communicatingly connected to one another in the manner that the coupled-in test voltage signal passes through the test section from the sending device to the receiving device, wherein the receiving device either detects or fails to detect a coupled-in test voltage signal as a function of a state of the test section, wherein upon detection of the test voltage signal a readable positive signal and upon non-detection of the test voltage signal, a readable negative signal to the receiving device.

In other words, a test voltage signal is coupled in by the measuring device according to the invention at least at one predetermined point of an electrical high-voltage conductor of a high-voltage vehicle electrical system which then passes through a test section of the high-voltage conductor. The coupling-in can take place upstream in particular with respect to a current direction which is defined by a current flowing through the electrical high-voltage conductor. The test voltage signal can subsequently be either detected or not detected by a receiving device in particular downstream of the test section, depending on whether the test section is electrically conductive or not. Upon detecting the test voltage signal at the receiving device, a readable positive signal is provided by the same which gives an indication of the electrically conductive state of the test section. Here, the term "readable" can signify that the positive signal is provided at the receiving device for a transmission or an evaluation. Upon non-detection of the test voltage signal at the receiving device, a readable negative signal is provided by the same which gives an indication of the electrically non-conductive state of the test section. The term "readable" here can mean that the negative signal is provided at the receiving device for a transmission or an evaluation, just like the positive signal.

The term "high-voltage" can be understood as voltages in the range of greater than or equal to 5 volts to greater than or equal to 1000 volts. In particular, the term "high-voltage" can be understood as 48 volts or 42 volts.

Thus, the measuring device according to the invention can altogether provide measuring signals by means of which a state of the test section can be determined. Since the measuring device according to the invention for providing the measuring signals merely detects the presence or absence of the test voltage signal, capacitive interference influences through capacitances introduced in the electrical high-voltage conductor or in the high-voltage vehicle electrical system have no influence. In other words, the measuring device is immune to capacitive influences. In particular, when the test section is formed by one or more switches, one or more fuses, in particular lead fuses, or the electrical high-voltage conductor itself, a quick and reliable detection of the state of these electrical components can thereby take place. Furthermore, by way of this, the detection of a state of the test section or of these electrical components is also possible in particular when the electrical high-voltage conductor or the high-voltage vehicle electrical system is isolated from a voltage source, i.e. a so-called no-load operation is present

The measuring signals provided by the measuring device according to the above description can be utilised for example for a diagnosis of the test section. For this purpose, it is practical when the sending device or the receiving device comprises a diagnostic unit which, by way of the measuring signals provided by the receiving device, determines an operating state of the test section. The diagnostic unit can evaluate the negative signal and the positive signal in order to provide a diagnosis regarding the test section for a user. For example, the diagnostic unit, when the test section is exemplarily realised by a fuse, can evaluate a received negative signal, i.e. non-detection of the test voltage signal at the receiving device, as an electrically non-conductive state of the fuse. Alternatively, the diagnostic unit can evaluate a received positive signal, i.e. detection of the test voltage signal at the receiving device, as a conductive state of the fuse.

It is practical when the test voltage signal is formed by a digital pulse width-modulated low-voltage signal or comprises such. The test voltage signal can be of relatively low power. Such a test voltage signal has the advantage that it can be relatively easily detected by the receiving device. More generally, the low power and high frequency nature of the test voltage signal has the advantage that it mitigates capacitive effects in the high-voltage vehicle electrical system.

Practically, the test voltage signal can have one or more frequencies. These frequencies are practically selected so that interferences through neighbouring electrical components of the high-voltage vehicle electrical system and/or high-voltage switching operations within the high-voltage vehicle electrical system are minimised. A test voltage signal equipped with corresponding frequencies has the advantage that it can be relatively easily detected by the receiving device.

Further practically, the sending device and/or the receiving device are/is arranged on the electrical high-voltage conductor and in each case is communicatingly connected or contacted with the same via an optocoupler. By way of this, the sending device, when it is in operation, can couple the test voltage signal relatively easily and practically interference-free, i.e. in particular without signal noise, into the electrical high-voltage conductor. Furthermore, the receiving device can thereby uncouple or accept and detect the coupled-in test voltage signal from the electrical high-voltage conductor. The optocouplers practically realise a galvanic isolation between the high-voltage vehicle electrical system or the high-voltage conductor and the sending device and/or the receiving device, so that the same cannot be damaged for example by over-voltage. Instead of optocouplers, other suitable isolation means can also be selected.

Practically, the test section can be formed by a switch or at least comprise such. Alternatively or additionally, the test section can be formed by a fuse, in particular a lead fuse, or at least comprise such. Further alternatively or additionally, the test section can be formed by a section of the said electrical high-voltage conductor or at least comprise such. In practice, the test section can have any electrical component or an arrangement of any electrical components. By way of this, a relatively large number of electrical components can be evaluated with respect to their state.

Further practically, the electrical high-voltage conductor can be subjected to an operating voltage of the high-voltage vehicle electrical system of 0 volt. By way of this, the detection of a state of the test section is also possible in particular when the electrical high-voltage conductor or the high-voltage vehicle electrical system is isolated from a voltage source, i.e. a so-called no load operation is present.

Practically, the electrical high-voltage conductor can be supplied with an operating voltage of the high-voltage vehicle electrical system greater than 0 volt, preferentially 48 volts, wherein the sending device, with respect to a current direction, which is defined by a current flowing through the electrical high-voltage conductor, is arranged upstream of the test section, as a result of which the test voltage signal is practically coupled in upstream of the test section. Furthermore, the receiving device can be arranged, with respect to the current direction, downstream of the test section. By way of this, the sending device and the receiving device enclose the test section between them. Because of this, the transmission section, through which the coupled-in test voltage signal has to pass, is practically relatively small. Because of this, interference influences can have a lesser or practically no effect on the test voltage signal, so that the measuring device is relatively insensitive to interference.

Practically, the test voltage signal coupled into the electrical high-voltage conductor during the operation of the sending device can form, by superposition, a superposition voltage with a continuous operating voltage of the high-voltage vehicle electrical system with which the electrical high-voltage conductor is supplied, of greater 0 volt, in particular 48 volt. Here, the said superposition voltage can materialise from superposition (accumulation) by time-discrete test voltages preset or presettable by the test voltage signal, which form the test voltage signal, with a continuous operating voltage, i.e. time-discreet operating voltages.

Further practically, the receiving device can be realised by a direct voltage measuring device. The direct voltage measuring device practically has an adequate receiving sensitivity, in particular frequency response sensitivity, in order to be able to reliably and quickly detect the test voltage signals coupled in by the sending device. In an embodiment of the measuring device, merely the said sending device can interact with such a direct voltage measuring device in order to monitor the test section of the measuring device.

Furthermore, the object mentioned at the outset is preferably solved through a diagnostic method for determining an operating state of a test section of an electrical high-voltage conductor of a high-voltage vehicle electrical system arranged in a vehicle, in particular an electrical vehicle, in particular a 48 volt direct high-voltage vehicle electrical system. Within the scope of this diagnostic method, the following steps are carried out with a measuring device according to the above description:
1) Starting up the sending device and the receiving device.
2) Providing a test voltage signal by means of the sending device and coupling this test voltage signal into the electrical high-voltage conductor of the high-voltage vehicle electrical system.
3) Here, the sending device and the receiving device can communicate with one another via the test section. As part of this communication:
4) either the coupled-in test voltage signal can be detected at the receiving device and provided at the diagnostic unit as measuring signal, which by evaluating the provided measuring signal and/or the test voltage signal recognises a first operating state of the test section and outputs the same if applicable, wherein the first operating state represents an electrically conductive state of the test section, in particular a closed state of a switch,
5) or the coupled-in test voltage signal cannot be detected at the receiving device, wherein the non-detection of the test voltage signal, in particular at the diagnostic unit, is recognised as second operating state, wherein the second operating state represents an electrically non-conductive state of the test section, in particular an open state of a switch.

It is practical when in step 2 of the diagnostic method the test voltage signal is coupled by the sending device into the electrical high-voltage conductor merely discontinuously. In particular, the coupling of the test voltage signal into the electrical high-voltage conductor can take place when the test section is formed by a switch that is open, i.e. electrically non-conductive.

Furthermore, the evaluation of the measuring signal provided and/or of the test voltage signal according to step 4) can be realised by way of a comparison of the frequency of the measuring signal with the frequency of the originally provided and coupled-in test voltage signal. This has the advantage that the recognition of the operating state of the test section of the high-voltage vehicle electrical system is relatively insensitive to capacitive discharge processes within the high-voltage vehicle electrical system.

It is practical when the electrical high-voltage conductor of the high-voltage vehicle electrical system is supplied with a preset or presettable continuous operating voltage, in particular 48 volt, wherein between the steps 2) and 3) of the diagnostic method a further step 2a) is inserted, thus the coupled-in test voltage signal superimposes itself on the continuous operating voltage and forms a superimposition voltage that is applied in the electrical high-voltage conductor and to the test section.

Another basic idea of the invention, which is realisable additionally or alternatively to the basic ideas mentioned further up can lie in stating a diagnostic method for determining an operating state of a test section of an electrical high-voltage conductor of a high-voltage vehicle electrical system arranged in a vehicle, in particular an electric vehicle, that with a measuring device according to the preceding description and with a switch that is electrically communicatingly incorporated in the electrical high-voltage conductor and an electric load that is electrically communicatingly incorporated in the electrical high-voltage conductor, wherein the electrical high-voltage conductor of the high-voltage vehicle electrical system is isolated from a preset or presettable continuous operating voltage, the following steps are carried out
1) Starting-up the sending device and of the receiving device.
2) Providing a test voltage signal by means of the sending device and coupling-in of this test voltage signal into the electrical high-voltage conductor at a point located downstream of the switch.
3) In the process, the sending device and the receiving device can communicate with one another via the test section, wherein
4) either the coupled-in test voltage signal on the electrical load is detected by means of the receiving unit and provided as measuring signal at the diagnostic unit, which through evaluation of the provided measuring signal and/or of the test voltage signal recognises a first operating state of the test section and outputs the same if applicable, wherein the first operating state represents an electrically conductive state of the test section, in particular a closed state of the electrical high-voltage conductor,
5) or the coupled-in test voltage signal is not detected on the electrical load by means of the receiving device, wherein the non-detection of the test voltage signal, in particular on the diagnostic unit, is recognised as second operating state, wherein the second operating state represents an electrically non-conductive state of the test section, in particular an open state of a switch.

Another basic idea of the invention, which is realisable additionally or alternatively to the basic ideas mentioned further up can lie in stating a use of a measuring device according to the above description in a high-voltage vehicle electrical system of a vehicle, in particular an electric vehicle, wherein the measuring device is integrated in the volt high-voltage vehicle electrical system and used in order to determine an operating state of a test section, in particular an electrical high-voltage conductor and/or a switch and/or a fuse and/or a lead fuse. In particular, the said measuring device can carry out the above described diagnostic method. Preferably, the said high-voltage vehicle electrical system can form a 5 volts to 1000 volts high-voltage vehicle electrical system or a 48 volt high-voltage vehicle electrical system.

In summary it should be noted: the present invention preferentially relates to a measuring device for a test section of a high-voltage vehicle electrical system arranged in a vehicle comprising: a sending device assigned to an electrical high-voltage conductor of a high-voltage vehicle electrical system which provides a test voltage signal and couples the same into the electrical high-voltage conductor, a receiving device assigned to the electrical high-voltage conductor, which can detect the coupled-in test voltage signal as measuring signal, an electrically conductive test section that is electrically connected to the electrical high-voltage conductor via which the sending device and the receiving device are communicatingly connected or connectable to one another, wherein the coupled-in test voltage signal passes through the test section from the sending device to the receiving device, wherein the receiving device detects or fails to detect a coupled-in test voltage signal, wherein upon detection of the same a positive signal and upon non-detection a negative signal is provided at the receiving device. Preferentially, the invention, furthermore, relates to a diagnostic method for determining an operating state of a test section of an electrical high-voltage conductor with a measuring device. Furthermore, the invention preferentially relates to a use of such a measuring device.

Further important features and advantages of the invention are obtained from the subclaims, from the drawings and from the associated figure description by way of the drawings.

Preferred exemplary embodiments of the invention are shown in the drawings and are explained in more detail in the following description, wherein same reference numbers relate to same or similar or functionally same components.

It shows, in each case schematically.
- Fig. 1: by way of an extract, an electrical high-voltage conductor of a high-voltage vehicle electrical system with a measuring device according to the invention in accordance with a first exemplary embodiment and
- Fig. 2: an electrical high-voltage conductor of a high-voltage vehicle electrical system with a measuring device according to the invention in accordance with a second exemplary embodiment.

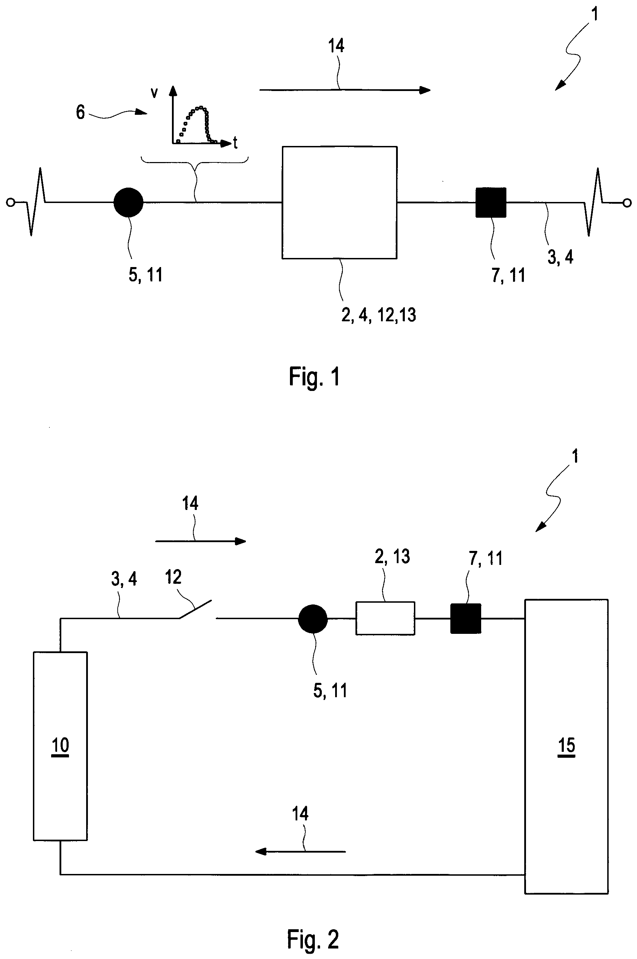

Fig. 1 and 2 show a measuring device marked altogether with the reference number 1, which can be utilised for the diagnosis of the state of an electrically conductive test section 2, which can be realised in particular by a switch 12, a lead fuse 13 or a section of an electrical high-voltage conductor 4. Here, the term diagnosis is practically understood in the sense of a status test, wherein basically an electrically conductive state of the electrically conductive test section 2 and an electrically non-conductive state of the electrically conductive test section 2 are distinguished, which is exemplarily explained for a test section 2 realised by a switch 12, where an electrically conductive state represents a closed switch 12 and an electrically non-conductive state an open or damaged switch 12.

In Fig. 1, a first exemplary embodiment of the measuring device 1 according to the invention is realised. Fig. 1 shows, by way of an example, an electrical high-voltage conductor 4 of a high-voltage electrical system 3, which is integrated for example in a vehicle. Furthermore, a measuring device 1 according to the invention is noticeable, which has a sending device 5 assigned to the electrical high-voltage conductor 4, which during its operation can provide a test voltage signal 6 and couple the same into this electrical high-voltage conductor 4. The sending device 5 is purely symbolically indicated by a filled-out circle superimposed on the electrical high-voltage conductor 4. The test voltage signal 6 is - likewise purely symbolically - indicated in a voltage-time diagram shown reduced in size. The test voltage signal 6 indicated therein with a dotted line is purely exemplary in nature. Furthermore, a receiving device 7 assigned to the electrical high-voltage conductor 4 is noticeable in Fig. 1, which is purely symbolically indicated by a filled-out small box that is superimposed on the electrical high-voltage conductor 4. The receiving device 7 can detect and provide as measuring signal the test voltage signal 6 coupled into the electrical high-voltage conductor 4. Furthermore, an electrically conductive test section 2 that is electrically conductively connected to the electrical high-voltage conductor 4, in particular integrated in the same, is indicated in Fig. 1, wherein for the sake of simplicity a box that is not filled in is used. The sending device 5 and the receiving device 7 are electrically communicatingly connected or at least connectable to one another via the test section 2, so that the coupled-in test voltage signal 6 can pass through the test section 2 emanating from the sending device 5 up to the receiving device 7. Now, the receiving device 7 detects, when during the operation of the sending device 5 a test voltage signal 6 is provided by the same and coupled into the electrical high-voltage conductor 4, either the coupled-in test voltage signal 6 or not, wherein upon detection of the coupled-in test voltage signal 6 a detected measuring signal as readable positive signal and upon non-detection of the test voltage signal 6 a readable negative signal is provided at the receiving device 7. Purely practically an electrically conductive state of the test section 2 is assigned to the positive signal and an electrically non-conductive state to the negative signal.

The illustrated measuring device 1 can monitor the test section 2 when the electrical high-voltage conductor 4 is supplied with an operating voltage of the high-voltage vehicle electrical system 3 of zero volt, which corresponds to a no-load operation of the high-voltage vehicle electrical system 3. Furthermore, the illustrated measuring device 1 can monitor the test section 2 when the electrical high-voltage conductor 4 is supplied with an operating voltage of the high-voltage vehicle electrical system 3 that is greater than zero volt, preferentially 48 volt, which corresponds to a normal operation of the high-voltage vehicle electrical system 3. In particular, in this normal operation of the high-voltage vehicle electrical system 3 the electrical high-voltage conductor 4 is flowed through by current, so that a current direction 14 is defined, which in Fig. 1 is indicated by a simple arrow. In this operating state of the high-voltage vehicle electrical system 3 it can also be said that the sending device 5, with respect to a current direction 14, which is defined by the current flowing through the electrical high-voltage vehicle conductor 4, are arranged upstream of the test section 2 and the receiving device 7 with respect to the current direction 14 downstream of the test section 2. Finally, the sending device 5 or the receiving device 7 additionally comprises a diagnostic unit 11 which is not indicated, which by way of the measuring signal provided by the receiving device 5 can determine and pass on to a user or a control unit or a terminal device the operating state of the test section 2.

Again making reference to Fig. 1, a diagnostic method for determining an operating state of the test section 2 of the electrical high-voltage conductor 4 can be carried out by means of the measuring device 1, in particular by means of the diagnostic unit 11 of the same. For this purpose it is initially provided that the sending device 5 and the receiving device 7 are put into operation, so that subsequently a test voltage signal 6 can be provided by the sending device 5 and coupled into the electrical high-voltage conductor 4. Since the sending device 5 and the receiving device 7 can basically communicate with one another via the test section 2, the test voltage signal 6 coupled in at the receiving device 7 can either be detected and provided as measuring signal at the diagnostic unit 11, wherein the diagnostic unit 11 by evaluating the provided measuring signal and/or the test voltage signal 6 deduces a first operating state of the test section 2 outputting the same if applicable, wherein the first operating state represents for example an electrically conductive state of the test section 2. Alternatively, the coupled-in test voltage signal 6 cannot be detected at the receiving device 7, wherein the non-detection of the test voltage signal 6 is evaluated by the diagnostic unit 11 as second operating state, wherein the second operating state represents for example an electrically non-conductive state of the test section 2.

A second exemplary embodiment of the invention is shown in Fig. 2, it illustrates an electrical high-voltage conductor 4 of a further high-voltage vehicle electrical system 3 with a measuring device 1 according to the invention in accordance with the first exemplary embodiment. In contrast with the preceding first exemplary embodiment, this measuring device 1 is provided for monitoring a test section 2 arranged between a switch 12 and an electrical load 15. For this purpose, the said switch 12 and the said measuring device 1 is provided on the electrical high-voltage conductor 4 according to the preceding first exemplary embodiment, wherein the latter has a sending device 5, a receiving device 7 and the test section 2. The test section 2 is exemplarily formed by a lead fuse 13, although additionally or alternatively a further switch or a section of the electrical high-voltage conductor 4 could be provided as test section 2. Furthermore, the second exemplary embodiment differs from the first exemplary embodiment in that, as already indicated, the electrical high-voltage conductor 4 comprising the test section 2 electrically connects a battery 10 with the electrical load 15. According to a diagnostic method according to the invention for determining an operating state of this test section 2 it is provided that the electrical high-voltage conductor 4 is isolated from a preset or presettable continuous operating voltage of the high-voltage vehicle electrical system 3, wherein the following steps are carried out:
1) starting up the sending device 5 and the receiving device 7,
2) providing a test voltage signal 6 by means of the sending device 5 and coupling this test voltage signal 6 into the electrical high-voltage conductor 4 at a point of the electrical high-voltage conductor 4 arranged downstream with respect to the switch 12, which with respect to a current direction 14, which is defined by a current flowing through the electrical high-voltage conductor 4 during normal operation, is situated downstream of the switch 12,
3) wherein the sending device 5 and the receiving device 7 communicate with one another via the test section 2, wherein
4) either the coupled-in test voltage signal 6 is detected at the electrical load 15 by means of the receiving device 7 and provided as measuring signal at the diagnostic unit 11, which by evaluating the provided measuring signal and/or the test voltage signal 6 recognises a first operating state of the test section 2 and outputs the same if applicable, wherein the first operating state represents an electrically conductive state of the test section 2,
5) or the coupled-in test voltage signal 6 is not detected at the electrical load 15 by means of the receiving device 7, wherein the non-detection of the test voltage signal 6 at the diagnostic unit 11 is recognised as second operating state, wherein the second operating state represents an electrically non-conductive state of the test section 2.

## Claims

1. A measuring device (1) for a test section (2) of a high-voltage vehicle electrical system (3) arranged in a vehicle, in particular an electric vehicle, comprising:
- a sending device (5) assigned to an electrical high-voltage conductor (4) of a high-voltage vehicle electrical system (3), which during its operation is configured to provide a test voltage signal (6) and to couple the same into this electrical high-voltage conductor (4),
- a receiving device (7) assigned to the electrical high-voltage conductor (4), which is configured to detect the test voltage signal (6) coupled into the electrical high-voltage conductor (4) as measuring signal,
- an electrically conductive test section (2) which is electrically conductively connected to the electrical high-voltage conductor (4), via which the sending device (5) and the receiving device (7) are electrically communicatingly connected to one another in the manner that the coupled-in test voltage signal (6) passes through the test section (2) from the sending device (5) to the receiving device (7),
- wherein the receiving device (7) is configured to either detect or fail to detect the coupled-in test voltage signal (6), wherein upon detection of the coupled-in test voltage signal (6) a detected measuring signal as readable positive signal and upon non-detection of the test voltage signal (6) a readable negative signal is provided at the receiving device (7), and
- wherein the sending device (5) and/or the receiving device (7) are arranged on the electrical high-voltage conductor (4) and in each case communicatingly connected with the same via an optocoupler.

2. The measuring device (1) according to Claim 1, wherein
the sending device (5) or the receiving device (7) comprises a diagnostic unit (11), which by way of the measuring signal provided by the receiving device (5) is configured to determine an operating state of the test section (2).

3. The measuring device (1) according to Claim 1 or 2, wherein
the test voltage signal (6) is formed by a digital pulse width-modulated low voltage signal or comprises such.

4. The measuring device (1) according to any one of the preceding claims, wherein
the test voltage signal (6) has one or more frequencies.

5. The measuring device (1) according to any one of the preceding claims, wherein
- the test section (2) is formed by a switch (12) or at least comprises such, and/or
- the test section (2) is formed by a fuse in particular lead fuse (13) or at least comprises such, and/or
- the test section (2) is formed by a section of the electrical high-voltage conductor (4) or at least comprises such.

6. The measuring device (1) according to any one of the preceding claims, wherein
the electrical high-voltage conductor (4) is configured to be supplied with an operating voltage of the high-voltage vehicle electrical system (3) of zero volt.

7. The measuring device (1) according to any one of the preceding claims, wherein
- the electrical high-voltage conductor (4) is configured to be supplied with an operating voltage of the high-voltage vehicle electrical system (3) that is greater than zero volt, preferentially 5 volts to 1000 volts or preferentially 48 volts,
- wherein the sending device (5), with respect to a current direction (14), which is defined by a current flowing through the electrical high-voltage conductor (4), is arranged upstream of the test section (2),
- wherein the receiving device (7) is arranged with respect to the current direction (14) downstream of the test section (2).

8. The measuring device (1) according to any one of the preceding claims, wherein
the test voltage signal (6) coupled into the electrical high-voltage conductor (4) during the operation of the sending device (5) is supplied or combined with a continuous operating voltage of the high-voltage vehicle electrical system (3), with which the electrical high-voltage conductor (4) is supplied, of greater than zero volt, in particular 5 volts to 1000 volts or preferentially 48 volts, to form a superposition voltage by superposition.

9. A diagnostic method for determining an operating state of a test section (2) of an electrical high-voltage conductor (4) of a high-voltage vehicle electrical system (3) arranged in a vehicle, in particular an electrical vehicle,
wherein the high-voltage vehicle electrical system (3) comprises a measuring device (1) according to any one of the preceding claims, and
wherein the method comprises the following steps carried out by the measuring device (1):
1) starting up the sending device (5) and the receiving device (7),
2) providing a test voltage signal (6) by means of the sending device (5) and coupling this test voltage signal (6) into the electrical high-voltage conductor (4) of the high-voltage vehicle electrical system (3),
3) wherein the sending device (5) and the receiving device (7) communicate with one another via the test section (2), wherein
4) either the coupled-in test signal (6) is detected at the receiving device (7) and provided as measuring signal at the diagnostic unit (11), which by evaluating the provided measuring signal recognises a first operating state of the test section (2) and outputs the same if applicable, wherein the first operating state represents an electrically conductive state of the test section (2), in particular a closed state of a switch (12) incorporated in the electrical high-voltage conductor (4) in an electrically communicating manner,
5) or the coupled-in test voltage signal (6) is not detected at the receiving device (7), wherein the non-detection of the test voltage signal (6) in particular at the diagnostic unit (11) is recognised as second operating state, wherein the second operating state represents an electrically non-conductive state of the test section (2), in particular an open state of the switch (12).

10. The diagnostic method according to Claim 9, wherein
in step 2) the test voltage signal (6) is merely discontinuously coupled into the electrical high-voltage conductor (4) by the sending device (5).

11. The diagnostic method according to Claim 9 or 10, wherein
the evaluation of the provided measuring signal and/or of the test voltage signal (6) according to step 4) is realised by a comparison of the frequency of the measuring signal with the frequency of the originally provided and coupled-in test voltage signal (6).

12. The diagnostic method according to Claim 9 to 11, wherein
- the electrical high-voltage conductor (4) of the high-voltage vehicle electrical system (3) is supplied with a predetermined or predeterminable continuous operating voltage, in particular 48 volts,
- wherein between the steps 2) and 3) a further step 2a) is inserted, according to which the coupled-in test voltage signal (6) is superimposed with the continuous operating voltage and forms a superimposition voltage, which is applied in the electrical high-voltage conductor (4) and to the test section (2).

13. A diagnostic method for determining an operating state of a test section (2) of an electrical voltage conductor (4) of a high-voltage electrical system (3) arranged in a vehicle, in particular an electric vehicle, wherein the high-voltage electrical system (3) comprises:
- a measuring device (1) according to the preceding claims 1 to 8, and
- a switch (12) which is incorporated in the electrical high-voltage conductor (4) in an electrically communicating manner and an electric load (15) which is electrically communicatingly incorporated in the electrical high-voltage conductor (4),
wherein the electrical high-voltage conductor (4) of the high-voltage vehicle electrical system (3) is isolated from a predetermined continuous operating voltage of the high-voltage vehicle electrical system (3), and
wherein the method comprises the following steps carried out by the measuring device (1):
1) starting up the sending device (5) and the receiving device (7),
2) providing a test voltage signal (6) by means of the sending device (5) and coupling this test voltage signal (6) into the electrical high-voltage conductor (4) at a point of the electrical high-voltage conductor (4) located downstream with respect to the switch (12),
3) wherein the sending device (5) and the receiving device (7) communicate with one another via the test section (2), wherein
4) either the coupled-in test voltage signal (6) is detected at the electrical load (15) by means of the receiving device (7) and provided at the diagnostic unit (11) as measuring signal, which through evaluation of the provided measuring signal recognises a first operating state of the test voltage (2) and outputs the same if applicable, wherein the first operating state represents an electrically conductive state of the test section (2), in particular a closed state of the electrical high-voltage conductor (4),
5) or the coupled-in test voltage signal (6) is not detected at the electrical load (15) by means of the receiving device (7), wherein the non-detection of the test voltage signal (6) in particular at the diagnostic unit (11) is recognised as second operating state, wherein the second operating state represents an electrically non-conductive state of the test section (2), in particular an open state of the switch (12).

14. A use of a measuring device (1) according to the Claims 1 to 8 in a 5 volts to 1000 volts or 48 volts high-voltage vehicle electrical system (3) of a vehicle, in particular of an electric vehicle, wherein the measuring device (1) is integrated in the 5 volts to 1000 volts or 48 volts high-voltage vehicle electrical system (3) and used for determining an operating state of a test section (2), in particular the test section (2) comprising an electrical high-voltage conductor (4) and/or a switch (12) and/or a lead fuse (13).

## Patentansprüche

1. Messvorrichtung (1) für einen Prüfabschnitt (2) eines in einem Fahrzeug, insbesondere einem Elektrofahrzeug, angeordneten Hochspannungs-Fahrzeugbordnetzes (3), umfassend:
- eine Sendevorrichtung (5), die einem elektrischen Hochspannungsleiter (4) eines Hochspannungs-Fahrzeugbordnetzes (3) zugeordnet ist und während ihres Betriebs konfiguriert ist, um ein Prüfspannungssignal (6) bereitzustellen und um dasselbe in den elektrischen Hochspannungsleiter (4) zu koppeln,
- eine Empfangsvorrichtung (7), die dem elektrischen Hochspannungsleiter (4) zugeordnet ist, der konfiguriert ist, um das in den elektrischen Hochspannungsleiter (4) eingekoppelte Prüfspannungssignal (6) als Messsignal zu erfassen,
- einen elektrisch leitfähigen Prüfabschnitt (2), der elektrisch leitfähig mit dem elektrischen Hochspannungsleiter (4) verbunden ist und über den die Sendevorrichtung (5) und die Empfangsvorrichtung (7) elektrisch kommunizierend derart miteinander verbunden sind, dass das eingekoppelte Prüfspannungssignal (6) durch den Prüfabschnitt (2) von der Sendevorrichtung (5) zur Empfangsvorrichtung (7) verläuft,
- wobei die Empfangsvorrichtung (7) konfiguriert ist, um das eingekoppelte Prüfspannungssignal (6) entweder zu erfassen oder nicht zu erfassen, wobei der Empfangsvorrichtung (7) bei Erfassen des eingekoppelten Prüfspannungssignals (6) ein erfasstes Messsignal als lesbares positives Signal und bei Nicht-Erfassen des Prüfspannungssignals (6) ein lesbares negatives Signal bereitgestellt wird und
- wobei die Sendevorrichtung (5) und/oder die Empfangsvorrichtungen (7) auf dem elektrischen Hochspannungsleiter (4) angeordnet sind und in jedem Fall über einen Optokoppler kommunizierend verbunden sind.

2. Messvorrichtung (1) nach Anspruch 1, wobei
die Sendevorrichtung (5) oder die Empfangsvorrichtung (7) eine Diagnoseeinheit (11) umfasst, die über das von der Empfangsvorrichtung (5) bereitgestellte Messsignal konfiguriert ist, um den Betriebszustand des Prüfabschnitts (2) zu bestimmen.

3. Messvorrichtung (1) nach Anspruch 1 oder 2, wobei das Prüfspannungssignal (6) aus einem digitalen pulsweitenmodulierten Niederspannungssignal gebildet wird oder ein solches umfasst.

4. Messvorrichtung (1) nach einem der vorstehenden Ansprüche, wobei das Prüfspannungssignal (6) eine oder mehrere Frequenzen aufweist.

5. Messvorrichtung (1) nach einem der vorstehenden Ansprüche, wobei
- der Prüfabschnitt (2) durch einen Schalter (12) gebildet ist oder mindestens einen solchen umfasst, und/oder
- der Prüfabschnitt (2) durch eine Sicherung, insbesondere eine Bleisicherung (13) gebildet wird oder mindestens eine solche umfasst, und/oder
- der Prüfabschnitt (2) durch einen Abschnitt des elektrischen Hochspannungsleiters (4) gebildet wird oder mindestens einen solchen umfasst.

6. Messvorrichtung (1) nach einem der vorstehenden Ansprüche, wobei der elektrische Hochspannungsleiter (4) konfiguriert ist, um mit einer Betriebsspannung des Hochspannungs-Fahrzeugbordnetzes (3) von null Volt versorgt zu werden.

7. Messvorrichtung (1) nach einem der vorstehenden Ansprüche, wobei
- der elektrische Hochspannungsleiter (4) konfiguriert ist, um mit einer Betriebsspannung des Hochspannungs-Fahrzeugbordnetzes (3) versorgt zu werden, die größer als null Volt, vorzugsweise 5 Volt bis 1000 Volt oder vorzugsweise 48 Volt, ist.
- wobei die Sendevorrichtung (5) in Bezug zu einer Stromrichtung (14), die durch einen durch den elektrischen Hochspannungsleiter (4) fließenden Strom definiert ist, stromaufwärts des Prüfabschnitts (2) angeordnet ist,
- wobei die Empfangsvorrichtung (7) in Bezug zur Stromrichtung (14) stromabwärts des Prüfabschnitts (2) angeordnet ist.

8. Messvorrichtung (1) nach einem der vorstehenden Ansprüche, wobei das während des Betriebs der Sendevorrichtung (5) in den elektrischen Hochspannungsleiter (4) eingekoppelte Prüfspannungssignal (6) mit einer kontinuierlichen Betriebsspannung des Hochspannungs-Fahrzeugbordnetzes (3), mit welcher der elektrische Hochspannungsleiter (4) versorgt wird, von mehr als null Volt, insbesondere 5 Volt bis 1000 Volt oder vorzugsweise 48 Volt, versorgt oder kombiniert wird, um durch Überlagerung eine Überlagerungsspannung zu bilden.

9. Diagnoseverfahren zum Bestimmen des Betriebszustands eines Prüfabschnitts (2) eines elektrischen Hochspannungsleiters (4) eines in einem Fahrzeug, insbesondere einem Elektrofahrzeug, angeordneten Hochspannungs-Fahrzeugbordnetzes (3),
wobei das Hochspannungs-Fahrzeugbordnetz (3) eine Messvorrichtung (1) nach einem der vorstehenden Ansprüche umfasst, und
wobei das Verfahren die folgenden Schritte umfasst, die von der Messvorrichtung (1) ausgeführt werden:
1) Starten der Sendevorrichtung (5) und der Empfangsvorrichtung (7),
2) Bereitstellen eines Prüfspannungssignals (6) mittels der Sendevorrichtung (5) und Koppeln dieses Prüfspannungssignals (6) in den elektrischen Hochspannungsleiter (4) des Hochspannungs-Fahrzeugbordnetzes (3),
3) wobei die Sendevorrichtung (5) und die Empfangsvorrichtung (7) über den Prüfabschnitt (2) miteinander kommunizieren, wobei
4) entweder das eingekoppelte Prüfsignal (6) an der Empfangsvorrichtung (7) erfasst wird und als Messsignal an der Diagnoseeinheit (11) bereitgestellt wird, die durch Auswerten des bereitgestellten Messsignals einen ersten Betriebszustand des Prüfabschnitts (2) erfasst und diesen gegebenenfalls ausgibt, wobei der erste Betriebszustand einen elektrisch leitenden Zustand des Prüfabschnitts (2), insbesondere einen geschlossenen Zustand eines Schalters (12), der in einer elektrisch kommunizierenden Art mit dem Hochspannungsleiter (4) eingebracht ist, darstellt,
5) oder das eingekoppelte Prüfspannungssignal (6) an der Empfangsvorrichtung (7) nicht erfasst wird, wobei die Nicht-Erfassung des Prüfspannungssignals (6), insbesondere an der Diagnoseeinheit (11), als zweiter Betriebszustand erkannt wird, wobei der zweite Betriebszustand einen elektrisch nichtleitenden Zustand des Prüfabschnitts (2), insbesondere einen offenen Zustand des Schalters (12), darstellt.

10. Diagnoseverfahren nach Anspruch 9, wobei in Schritt 2) das Prüfspannungssignal (6) mittels der Sendevorrichtung (5) lediglich diskontinuierlich in den elektrischen Hochspannungsleiter (4) eingekoppelt wird.

11. Diagnoseverfahren nach Anspruch 9 oder 10, wobei die Auswertung des bereitgestellten Messsignals und/oder des Prüfspannungssignals (6) gemäß Schritt 4) durch einen Vergleich der Frequenz des Messsignals mit der Frequenz des ursprünglich bereitgestellten und eingekoppelten Prüfspannungssignals (6) erfolgt.

12. Diagnoseverfahren nach Anspruch 9 bis 11, wobei
- der elektrische Hochspannungsleiter (4) des Hochspannungs-Fahrzeugbordnetzes
(3) mit einer vorbestimmten oder vorbestimmbaren kontinuierlichen Betriebsspannung, insbesondere 48 Volt, versorgt wird,
- wobei zwischen den Schritten 2) und 3) ein weiterer Schritt 2a) eingefügt wird, demgemäß das eingekoppelte Prüfspannungssignal (6) mit der kontinuierlichen Betriebsspannung überlagert wird und eine Überlagerungsspannung bildet, die an den elektrischen Hochspannungsleiter (4) und an den Prüfabschnitt (2) angelegt wird.

13. Diagnoseverfahren zum Bestimmen des Betriebszustands eines Prüfabschnitts (2) eines elektrischen Spannungsleiters (4) eines in einem Fahrzeug, insbesondere einem Elektrofahrzeug, angeordneten Hochspannungs-Fahrzeugbordnetzes (3),
wobei das Hochspannungs-Fahrzeugbordnetz (3) umfasst:
- eine Messvorrichtung (1) nach den vorstehenden Ansprüchen 1 bis 8, und
- einen Schalter (12), der in einer elektrisch kommunizierenden Art mit dem elektrischen Hochspannungsleiter (4) verbunden ist, und eine elektrische Last (15), die elektrisch kommunizierend in den elektrischen Hochspannungsleiter (4) einbezogen ist,
wobei der elektrische Hochspannungsleiter (4) des Hochspannungs-Fahrzeugbordnetzes (3) von einer vorbestimmten kontinuierlichen Betriebsspannung des Hochspannungs-Fahrzeugbordnetzes (3) isoliert ist, und
wobei das Verfahren die folgenden Schritte umfasst, die von der Messvorrichtung (1) ausgeführt werden:
1) Starten der Sendevorrichtung (5) und der Empfangsvorrichtung (7),
2) Bereitstellen eines Prüfspannungssignals (6) mittels der Sendevorrichtung (5) und Koppeln dieses Prüfspannungssignals (6) in den elektrischen Hochspannungsleiter (4) an einer Stelle des elektrischen Hochspannungsleiters (4), die sich stromabwärts des Schalters (12) befindet,
3) wobei die Sendevorrichtung (5) und die Empfangsvorrichtung (7) über den Prüfabschnitt (2) miteinander kommunizieren, wobei
4) entweder das eingekoppelte Prüfspannungssignal (6) an der elektrischen Last (15) mittels der Empfangsvorrichtung (7) erfasst wird und an der Diagnoseeinheit (11) als Messsignal bereitgestellt wird, die durch Auswerten des bereitgestellten Messsignals einen ersten Betriebszustand des Prüfabschnitts (2) erfasst und diesen gegebenenfalls ausgibt, wobei der erste Betriebszustand einen elektrisch leitenden Zustand der Prüfspannung (2), insbesondere einen geschlossenen Zustand des Hochspannungsleiters (4) darstellt,
5) oder das eingekoppelte Prüfspannungssignal (6) an der elektrischen Last (15) mittels der Empfangsvorrichtung (7) nicht erfasst wird, wobei die Nicht-Erfassung des Prüfspannungssignals (6), insbesondere an der Diagnoseeinheit (11), als zweiter Betriebszustand erkannt wird, wobei der zweite Betriebszustand einen elektrisch nichtleitenden Zustand des Prüfabschnitts (2), insbesondere einen offenen Zustand des Schalters (12), darstellt.

14. Verwendung einer Messvorrichtung (1) nach den Ansprüchen 1 bis 8 in einem 5-Volt- bis 1000-Volt- oder 48-Volt-Hochspannungs-Fahrzeugbordnetz (3), insbesondere eines Elektrofahrzeugs, wobei die Messvorrichtung (1) in das 5-Volt- bis 1000-Volt- oder 48-Volt-Hochspannungs-Bordnetz (3) integriert ist und zum Bestimmen eines Betriebszustands eines Prüfabschnitts (2), insbesondere des Prüfabschnitts (2), der einen elektrischen Hochspannungsleiter (4) und/oder einen Schalter (12) und/oder eine Bleisicherung (13) umfasst, verwendet wird.

## Revendications

1. Dispositif de mesure (1) pour une section de test (2) d'un système électrique haute tension de véhicule (3) agencé dans un véhicule, en particulier un véhicule électrique, comprenant :
- un dispositif d'envoi (5) affecté à un conducteur électrique haute tension (4) d'un système électrique haute tension de véhicule (3), qui, pendant son fonctionnement, est configuré pour fournir un signal de tension de test (6) et pour coupler celui-ci à ce conducteur électrique haute tension (4),
- un dispositif de réception (7) affecté au conducteur électrique haute tension (4), qui est configuré pour détecter le signal de tension de test (6) couplé au conducteur électrique haute tension (4) comme signal de mesure,
- une section de test électriquement conductrice (2) qui est connectée de manière électriquement conductrice au conducteur électrique haute tension (4), par l'intermédiaire de laquelle le dispositif d'envoi (5) et le dispositif de réception (7) sont connectés électriquement de manière à communiquer électriquement l'un à l'autre de sorte que le signal de tension de test (6) couplé passe par la section de test (2) du dispositif d'envoi (5) au dispositif de réception (7),
- dans lequel le dispositif de réception (7) est configuré pour détecter ou non le signal de tension de test (6) couplé, dans lequel, lors de la détection du signal de tension de test (6) couplé, un signal de mesure détecté comme signal positif lisible et, lors de la non-détection du signal de tension de test (6), un signal négatif lisible sont fournis au niveau du dispositif de réception (7), et
- dans lequel le dispositif d'envoi (5) et/ou le dispositif de réception (7) sont agencés sur le conducteur électrique haute tension (4) et, dans chaque cas, connectés en communication avec celui-ci via un optocoupleur.

2. Dispositif de mesure (1) selon la revendication 1, dans lequel
le dispositif d'envoi (5) ou le dispositif de réception (7) comprend une unité de diagnostic (11), qui, au moyen du signal de mesure fourni par le dispositif de réception (5), est configurée pour déterminer un état de fonctionnement de la section de test (2).

3. Dispositif de mesure (1) selon la revendication 1 ou 2, dans lequel le signal de tension de test (6) est formé par un signal numérique basse tension modulé en largeur d'impulsion ou comprend un tel signal.

4. Dispositif de mesure (1) selon l'une quelconque des revendications précédentes, dans lequel le signal de tension de test (6) présente une ou plusieurs fréquences.

5. Procédé selon l'une quelconque des revendications précédentes, dans lequel
- la section de test (2) est formée par un commutateur (12) ou au moins comprend un tel commutateur, et/ou
- la section de test (2) est formée par un fusible, en particulier un fusible en plomb (13), ou au moins comprend un tel fusible, et/ou
- la section de test (2) est formée par une section du conducteur électrique haute tension (4) ou au moins comprend une telle section.

6. Dispositif de mesure (1) selon l'une quelconque des revendications précédentes, dans lequel le conducteur électrique haute tension (4) est configuré pour être alimenté par une tension de fonctionnement du système électrique haute tension de véhicule (3) de zéro volt.

7. Procédé selon l'une quelconque des revendications précédentes, dans lequel
- le conducteur électrique haute tension (4) est configuré pour être alimenté par une tension de fonctionnement du système électrique haute tension de véhicule (3) supérieure à zéro volt, de préférence de 5 volts à 1000 volts ou de préférence de 48 volts,
- dans lequel le dispositif d'envoi (5), par rapport à une direction de courant (14), qui est définie par un courant circulant dans le conducteur électrique haute tension (4), est agencé en amont de la section de test (2),
- dans lequel le dispositif de réception (7) est agencé, par rapport à la direction de courant (14), en aval de la section de test (2).

8. Dispositif de mesure (1) selon l'une quelconque des revendications précédentes, dans lequel le signal de tension de test (6) couplé au conducteur électrique haute tension (4) pendant le fonctionnement du dispositif d'envoi (5) est fourni ou combiné avec une tension de fonctionnement continue du système électrique haute tension de véhicule (3), qui alimente le conducteur électrique haute tension (4), supérieure à zéro volt, en particulier de 5 volts à 1000 volts ou de préférence de 48 volts, pour former une tension de superposition par superposition.

9. Procédé de diagnostic pour déterminer un état de fonctionnement d'une section de test (2) d'un conducteur électrique haute tension (4) d'un système électrique haute tension de véhicule (3) agencé dans un véhicule, en particulier un véhicule électrique,
dans lequel le système électrique haute tension de véhicule (3) comprend un dispositif de mesure (1) selon l'une quelconque des revendications précédentes, et
dans lequel le procédé comprend les étapes suivantes réalisées par le dispositif de mesure (1) :
1) le démarrage du dispositif d'envoi (5) et du dispositif de réception (7),
2) la fourniture d'un signal de tension de test (6) au moyen du dispositif d'envoi (5) et le couplage de ce signal de tension de test (6) au conducteur électrique haute tension (4) du système électrique haute tension de véhicule (3),
3) dans lequel le dispositif d'envoi (5) et le dispositif de réception (7) communiquent entre eux via la section de test (2), dans lequel
4) soit le signal de test (6) couplé est détecté au niveau du dispositif de réception (7) et fourni comme signal de mesure à l'unité de diagnostic (11), laquelle, en évaluant le signal de mesure fourni, reconnaît un premier état de fonctionnement de la section de test (2) et le restitue le cas échéant, dans lequel le premier état de fonctionnement représente un état électriquement conducteur de la section de test (2), en particulier un état fermé d'un commutateur (12) incorporé dans le conducteur électrique haute tension (4) de manière à communiquer électriquement,
5) soit le signal de tension de test (6) couplé n'est pas détecté au niveau du dispositif de réception (7), dans lequel la non-détection du signal de tension de test (6) en particulier au niveau de l'unité de diagnostic (11) est reconnue comme un second état de fonctionnement, dans lequel le second état de fonctionnement représentant un état électriquement non conducteur de la section de test (2), en particulier un état ouvert du commutateur (12).

10. Procédé de diagnostic selon la revendication 9, dans lequel, à l'étape 2), le signal de tension de test (6) est simplement couplé de manière discontinue au conducteur électrique haute tension (4) par le dispositif d'envoi (5).

11. Procédé de diagnostic selon la revendication 9 ou 10, dans lequel l'évaluation du signal de mesure fourni et/ou du signal de tension de test (6) selon l'étape 4) est réalisée par une comparaison de la fréquence du signal de mesure à la fréquence du signal de tension de test (6) initialement fourni et couplé.

12. Procédé de diagnostic selon les revendications 9 à 11, dans lequel
- le conducteur électrique haute tension (4) du système électrique haute tension de véhicule (3) est alimenté par une tension de fonctionnement continue prédéterminée ou pouvant être prédéterminée, en particulier de 48 volts,
- dans lequel, entre les étapes 2) et 3), une étape supplémentaire 2a) est insérée, selon laquelle le signal de tension de test (6) couplé est superposé à la tension de fonctionnement continue et forme une tension de superposition, qui est appliquée dans le conducteur électrique haute tension (4) et à la section de test (2).

13. Procédé de diagnostic pour déterminer un état de fonctionnement d'une section de test (2) d'un conducteur de tension électrique (4) d'un système électrique haute tension (3) agencé dans un véhicule, en particulier un véhicule électrique,
dans lequel le système électrique haute tension (3) comprend :
- un dispositif de mesure (1) selon les revendications 1 à 8 précédentes, et
- un commutateur (12) qui est incorporé dans le conducteur électrique haute tension (4) de manière à communiquer électriquement et une charge électrique (15) qui est incorporée de manière à communiquer électriquement dans le conducteur électrique haute tension (4),
dans lequel le conducteur électrique haute tension (4) du système électrique haute tension de véhicule (3) est isolé d'une tension de fonctionnement continue prédéterminée du système électrique haute tension de véhicule (3), et
dans lequel le procédé comprend les étapes suivantes réalisées par le dispositif de mesure (1) :
1) le démarrage du dispositif d'envoi (5) et du dispositif de réception (7),
2) la fourniture d'un signal de tension de test (6) au moyen du dispositif d'envoi (5) et le couplage de ce signal de tension de test (6) au conducteur électrique haute tension (4) à un point du conducteur électrique haute tension (4) situé en aval par rapport au commutateur (12),
3) dans lequel le dispositif d'envoi (5) et le dispositif de réception (7) communiquent entre eux via la section de test (2), dans lequel
4) soit le signal de tension de test (6) couplé est détecté à la charge électrique (15) au moyen du dispositif de réception (7) et fourni à l'unité de diagnostic (11) comme signal de mesure, qui, par l'évaluation du signal de mesure fourni, reconnaît un premier état de fonctionnement de la tension de test (2) et le restitue le cas échéant, dans lequel le premier état de fonctionnement représente un état électriquement conducteur de la section de test (2), en particulier un état fermé du conducteur électrique haute tension (4),
5) soit le signal de tension de test (6) couplé n'est pas détecté au niveau de la charge électrique (15) au moyen du dispositif de réception (7), dans lequel la non-détection du signal de tension de test (6) en particulier au niveau de l'unité de diagnostic (11) est reconnue comme un second état de fonctionnement, dans lequel le second état de fonctionnement représente un état électriquement non conducteur de la section de test (2), en particulier un état ouvert du commutateur (12).

14. Utilisation d'un dispositif de mesure (1) selon les revendications 1 à 8 dans un système électrique haute tension de véhicule (3) de 5 volts à 1000 volts ou de 48 volts d'un véhicule, en particulier d'un véhicule électrique, dans laquelle le dispositif de mesure (1) est intégré au système électrique haute tension de véhicule (3) de 5 volts à 1000 volts ou de 48 volts et utilisé pour déterminer un état de fonctionnement d'une section de test (2), en particulier la section de test (2) comprenant un conducteur électrique haute tension (4) et/ou un commutateur (12) et/ou un fusible en plomb (13).
